Europäisches Patentamt

European Patent Office

Office européen des brevets

(11) Veröffentlichungsnummer: **0 454 902 A2**

## (12) EUROPÄISCHE PATENTANMELDUNG

(21) Anmeldenummer: 90123353.6

(22) Anmeldetag: 05.12.90

(51) Int. Cl.5: **H01L 27/15**, H01S 3/085

(30) Priorität: 03.05.90 DE 4014234

(43) Veröffentlichungstag der Anmeldung:
06.11.91 Patentblatt 91/45

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Thulke, Wolfgang, Dr. rer. nat.**
**Neubiberger Strasse 38**
**W-8000 München 83(DE)**

(54) **Monolithisch integrierter Schaltkreis mit DFB-Laserdiode, optischem Schalter und Wellenleiterverbindungen.**

(57) Monolithisch integrierter Schaltkreis mit einer DFB-Laserdiode, einem optischen Schalter und Wellenleitern, die als Steg ausgebildet sind, sowie einer derartigen Anordnung der Laserdiode in bezug auf den Wellenleiter, daß die in der Laserdiode im Betrieb des Schaltkreises erzeugte Strahlung durch Stoßkopplung in einen longitudinal an die Laserdiode angrenzenden und in der Längsrichtung der Laserdiode ausgerichteten Teil des Wellenleiters eingekoppelt wird und der optische Schalter in den Steg eines Wellenleiters integriert ist.

## FIG 1

EP 0 454 902 A2

Die vorliegende Erfindung betrifft die monolithische Integration einer DFB-Laserdiode mit einem optischen Schalter und passiven Wellenleiterverbindungen gemäß den Merkmalen des Oberbegriffs des Anspruches 1.

Monolithisch integrierte Schaltkreise mit Laserdioden, optischen Schaltern und passiven Wellenleitern werden als Schlüsselkomponenten optischer Nachrichtenübertragungssysteme betrachtet, da diese Schaltkreise kostengünstige Realisierungen von Signal-Verteilerschaltungen und anderen Systemelementen ermöglichen. Die verlustarme Ankopplung der Laserdioden und der Schalter an passive Wellenleiter ist eine wesentliche Voraussetzung für die Funktionsfähigkeit des integrierten Schaltkreises. Beim optischen Schalter ist dieses technische Problem der Ankopplung verhältnismäßig leicht zu lösen. Die Bauform leistungsfähiger optischer Schalter entspricht der von passiven Rippenwellenleitern (R.G.Hunsperger: "Integrated Optics: Theory and Technology, Springer Verlag, Berlin 1982, S. 43 ff.). Die monolithische Integration von leistungsfähigen Laserdioden mit solchen optischen Schaltern ist das technische Problem, das mit der vorliegenden Erfindung gelöst wird. Für die monolithische Integration eignen sich vor allem Laser mit vergrabener Heterostruktur. Ihre aktive Zone ist an allen Längsseiten von Halbleitermaterial mit größerer Bandlückenenergie und kleinerer Brechzahl begrenzt. Mit dieser Bauform wird ein geringer Schwellenstrom erreicht, da sowohl die Ladungsträger als auch das optische Wellenfeld allseitig eingeschlossen sind bzw. geführt werden. Die im Betrieb der Laserdiode entstehende Verlustleistung wird dadurch gering gehalten, die Beeinträchtigung anderer integrierter Komponenten durch die entstehende Wärme bleibt ebenfalls geringfügig.

Die Integration einer DBR-Laserdiode mit vergrabener Heterostruktur und eines optischen Schalters in der Bauform eines vergrabenen Rippenwellenleiters wird in der Literatur beschrieben (F. Hernandez-Gil et. al., Proc. CLEO 1989, Baltimore, pap. PD 17-1/2). Die Laserstruktur ist bei diesem Aufbau über dem durchgehenden passiven Wellenleiter angeordnet. Die seitliche Begrenzung des Laserstreifens und die Verdeckung des (vergrabenen) Wellenleiters bestehen aus semiisolierendem Halbleitermaterial, dessen Herstellung nicht mit allen prinzipiell verfügbaren Verfahren möglich ist. Die Anordnung der Wellenleiterschicht unter dem Laser beeinträchtigt die Eigenschaften des Lasers, oder sie zwingt zu einer Wellenleitergeometrie und -zusammensetzung, die die optischen Eigenschaften des Wellenleiters des Schalters verschlechtert.

Aufgabe der vorliegenden Erfindung ist es, einen Aufbau für ein Bauelement anzugeben, bei dem in passive Wellenleiter in der Bauform von Stegwellenleitern mindestens ein optischer Schalter, der ebenfalls die Bauform eines Stegwellenleiters aufweist, und eine DFB-Laserdiode monolithisch integriert sind.

Diese Aufgabe wird mit dem monolithisch integrierten Schaltkreis mit den Merkmalen des Anspruches 1 gelöst. Weitere Ausgestaltungen ergeben sich aus den Unteransprüchen.

Es folgt eine Beschreibung des erfindungsgemäßen Aufbaus anhand der Figuren 1 bis 34.

Fig. 1          zeigt eine schematische Draufsicht auf die erfindungsgemäße Anordnung.

Fig. 2          zeigt den Übergang zwischen Laserdiode und passivem Wellenleiter im Längsschnitt.

Fig. 3          zeigt den Aufbau im Bereich der Laserdiode im Querschnitt.

Fig. 4          zeigt den Aufbau im Bereich des optischen Schalters im Querschnitt.

Fig. 5 bis 34   zeigen den erfindungsgemäßen Aufbau jeweils in einem Schritt der Herstellung, wobei jeweils drei aufeinanderfolgende Figuren den Aufbau im Bereich der Laserdiode im Querschnitt, den Aufbau im Bereich des Überganges von der Laserdiode zum passiven Wellenleiter im Längsschnitt und den Bereich des passiven Wellenleiters bzw. des optischen Schalters im Querschnitt zeigen.

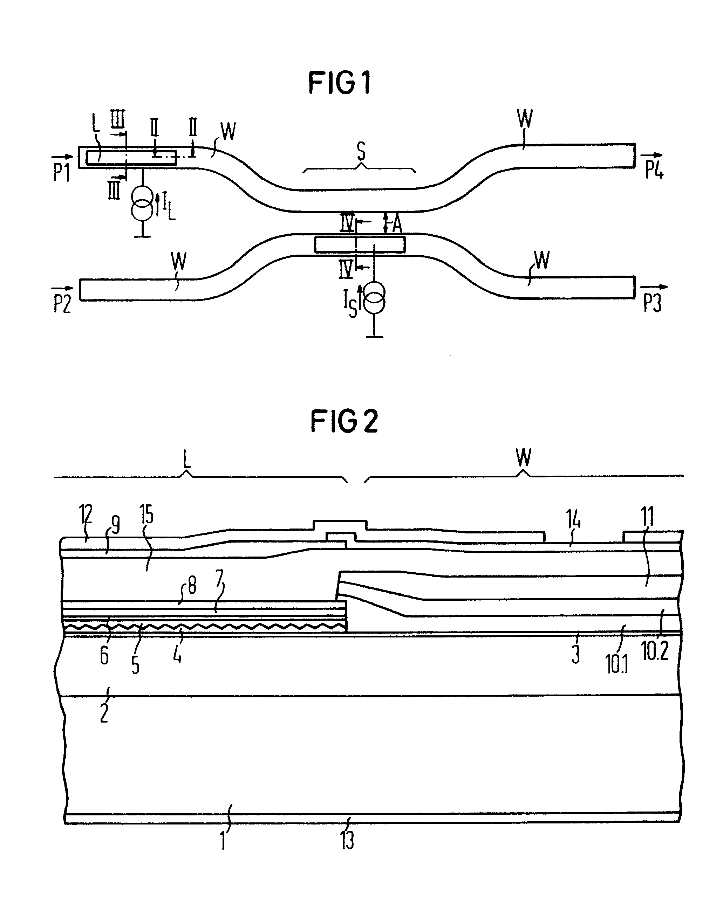

Fig. 1 zeigt die erfindungsgemäße Laser-Schalter-Wellenleiter-Struktur in einer schematischen Draufsicht. Dargestellt sind die Wellenleiter W mit den Lichteingängen Port 1 P1 und Port 2 P2 und den Lichtausgängen Port 3 P3 und Port 4 P4. An Port 1 P1 befindet sich die Laserdiode L mit dem zum Betrieb angelegten Laserstrom $I_L$. Im Bereich des Schalters S sind die Wellenleiterstege bis auf einen Abstand A einander angenähert. Der Schalter wird über einen Schalterstrom $I_S$ betrieben. Fig. 1 zeigt ein Ausführungsbeispiel in einer vereinfachten Draufsicht ohne aufgebrachte Kontakt-Metallisierung. Es sind davon abweichende Anordnungen von Laserdioden, insbesondere auch mehreren Laserdioden und optischen Schaltern in Stegwellenleitern in dem erfinaungsgemäßen Aufbau inbegriffen.

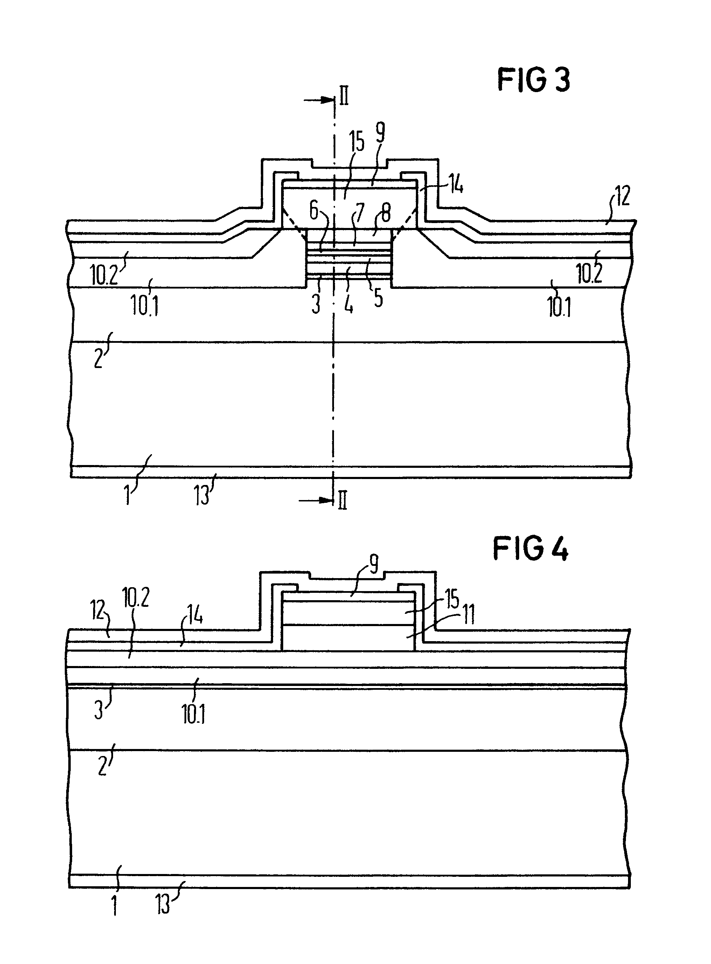

Fig. 2 zeigt den Übergang von der Laserdiode zum Wellenleiter im Längsschnitt entsprechend dem in Fig. 1 eingezeichneten Schnitt. Der passive Stegwellenleiter, der in Fig. 2 auf der rechten Seite dargestellt ist, geht in fast unveränderter Form in den optischen Schalter über. Dieser optische Schalter ist nicht in Fig. 2 dargestellt und wird weiter unten anhand von Fig. 4 beschrieben. Bei dem Ausführungsbeispiel nach Fig. 2 befindet sich der integrierte Schaltkreis auf einem Substrat 1 aus z.B. InP eines ersten Leitfähigkeitstyps (z.B. n-leitend). Auf dieses Substrat 1 sind Halbleiterschichten epitaktisch aufgewachsen. Die erste auf das Substrat 1 aufgewachsene Schicht ist eine Pufferschicht 2 des gleichen ersten Leitfähigkeitstyps, z.B.

2

ebenfalls aus InP. Bei ausreichender Qualität der überwachsenen Oberfläche des Substrates 1 kann diese Pufferschicht 2 auch entfallen. Auf diese Pufferschicht 2 ist eine dünne Ätzstoppschicht 3 einer von der Zusammensetzung der Pufferschicht 2 verschiedenen Zusammensetzung (z.B. InGaAsP), aber vom gleichen ersten Leitfähigkeitstyp aufgewachsen. Diese Ätzstoppschicht 3 unterscheidet sich in ihrer Löslichkeit in bestimmten Säuren (z.B. HCl) von der Pufferschicht 2 bzw. dem Substrat 1. Die Pufferschicht 2 und die Ätzstoppschicht 3 befinden sich in dem gesamten von den Funktionselementen dieses Schaltkreises eingenommenen Bereich.

Im Bereich der Laserdiode L (in Fig. 2 auf der linken Seite) ist auf der Ätzstoppschicht 3 eine erste Gitterschicht 4 mit niedriger Brechzahl aus z.B. InP vom ersten Leitfähigkeitstyp aufgewachsen. In der Oberfläche dieser ersten Gitterschicht 4 ist ein DFB-Gitter ausgebildet. Die Gitterperiode dieses DFB-Gitters entspricht der Wellenlänge des Lichtes im Halbleitermaterial oder einem ganzzahligen Vielfachen davon. Auf diese erste Gitterschicht 4 ist eine zweite Gitterschicht 5 einer größeren Brechzahl als der der ersten Gitterschicht 4 aufgewachsen. Diese zweite Gitterschicht 5 ist z.B. InGaAsP und ist ebenfalls für elektrische Leitung des ersten Leitfähigkeitstyps dotiert. Diese zweite Gitterschicht 5 gleicht die Unebenheit des Gitters aus, so daß die zweite Gitterschicht 5 eine ebene Grenzfläche zu einer darüber aufgewachsenen aktiven Schicht 6 besitzt. Diese aktive Schicht 6 besitzt die größte Brechzahl aller aufgewachsenen Schichten und ist z.B. InGaAsP. Die Materialzusammensetzung dieser aktiven Schicht 6 bestimmt die Lage des Verstärkungsmaximums des Lasers in dem Spektrum des Lasers. Auf die aktive Schicht 6 ist mindestens eine Anti-melt-back-Schicht 7 (Antirücklöseschicht) aufgewachsen. Diese Anti-melt-back-Schicht 7 ist für einen dem ersten entgegengesetzten zweiten Leitfähigkeitstyp (bei diesem Ausführungsbeispiel p-leitend) dotiert und schützt die aktive Schicht 6 beim Herstellungsprozeß vor schädigenden Einflüssen.

Auf diese Anti-melt-back-Schicht 7 ist gegebenenfalls die in Fig. 2 eingezeichnete weitere Anti-melt-back-Schicht 8 aufgewachsen. Diese weitere Anti-melt-back-Schicht 8 ist z. B. InP und ist für den zweiten Leitfähigkeitstyp dotiert. Sie kann gleichzeitig zu einer lateralen Begrenzung des Stromflusses auf den Bereich des Laserstreifens dienen. Diese weitere Anti-melt-back-Schicht 8 kann auch weggelassen werden.

Die Laserschichten, d.h. die erste Gitterschicht 4, die zweite Gitterschicht 5, die aktive Schicht 6 und die Anti-melt-back-Schicht 7 sind in longitudinaler und lateraler Richtung von einer oder mehreren Wellenleiterschichten 10.1, 10.2 begrenzt. In dem Bereich des Wellenleiters W auf der rechten Seite in Fig. 2 sind in dem vorliegenden Ausführungsbeispiel eine erste Wellenleiterschicht 10.1, eine zweite Wellenleiterschicht 10.2 und eine erste Mantelschicht 11 vorhanden. Eine durchgehende zweite Mantelschicht 15 bedeckt die Laserdiode L und den Bereich des Wellenleiters W. Die erste Wellenleiterschicht 10.1 und die zweite Wellenleiterschicht 10.2 und ggf. weitere Wellenleiterschichten sind nominell undotiert, damit die optische Dämpfung in ihnen gering ist. Die Zusammensetzung der Wellenleiterschichten 10.1, 10.2 (in diesem Ausführungsbeispiel InGaAsP) ist so gewählt, daß ihre Brechzahlen kleiner sind als die der aktiven Schicht 6, aber größer als die des Substrates 1 bzw. der Pufferschicht 2 und der ersten Mantelschicht 11. Die erste Mantelschicht 11 (aus z.B. InP) ist für elektrische Leitung des zweiten Leitfähigkeitstyps dotiert; diese Dotierung ist aber niedrig, um die optische Dämpfung der in diese erste Mantelschicht 11 hineinreichenden optischen Welle gering zu halten.

Die durchgehend aufgewachsene zweite Mantelschicht 15 aus z.B. InP ist vom zweiten Leitfähigkeitstyp und kann im Bereich der Laserdiode L durch eine Verschmälerung in Richtung auf die aktive Schicht 6 zu einer lateralen Begrenzung des Stromflusses auf den Bereich des Laserstreifens dienen. Auf diese zweite Mantelschicht 15 ist im Bereich der Laserdiode L eine Kontaktschicht 9 aufgebracht. Diese Kontaktschicht 9 ist z.B. InGaAsP und hoch für elektrische Leitung des zweiten Leitfähigkeitstyps dotiert. Auf die zweite Manteschicht 15 ist eine Passivierungsschicht 14 aus einem Dielektrikum (z.B. ein isolierendes Oxid) aufgebracht. Diese Passivierungsschicht 14 läßt die für die Kontaktierung vorgesehenen Bereiche der Oberfläche der Kontaktschicht 9 frei. Auf diese Bereiche der Kontaktschicht 9 ist eine erste Metallisierung 12 aufgebracht. In den passiven Bereichen wird diese erste Metallisierung 12 durch die Passivierungsschicht 14 von der zweiten Mantelschicht 15 isoliert. Diese erste Metallisierungsschicht 12 ist in longitudinaler und ggf. lateraler Richtung unterbrochen, um ein getrenntes elektrisches Ansteuern der Laserdiode und des Schalters zu ermöglichen. Eine zweite Metallisierung 13 ist als Schicht ganzflächig auf die der überwachsenen Seite gegenüberliegenden Oberfläche des (leitfähigen) Substrates 1 aufgebracht und dient als gemeinsamer elektrischer Anschluß für alle auf dem Bauelement integrierten Funktionselemente.

Fig. 3 zeigt den in Fig. 1 bezeichneten Querschnitt durch die Laserdiode L. Auf dem Substrat 1 befindet sich die Pufferschicht 2 und in dem streifenförmigen Bereich des Lasers übereinander und lateral auf einen Streifen begrenzt die Ätzstoppschicht 3, darauf die erste Gitterschicht 4, die zweite Gitterschicht 5, die aktive Schicht 6, die Anti-melt-back-Schicht 7 und gegebenenfalls eine weitere Anti-melt-back-Schicht 8 und die zweite Mantelschicht 15. Die laterale Begrenzung des Laserstreifens ist durch die erste Wellenleiterschicht 10.1 und die zweite Wellenleiterschicht 10.2 gegeben. Die Passivierungsschicht 14 läßt auf dem

3

Steg einen streifenförmigen für die Kontaktierung vorgesehenen Bereich der auf die zweite Mantelschicht 15 aufgebrachten Kontaktschicht 9 frei. Die elektrische Kontaktierung erfolgt über die erste Metallisierung 12, die durch die Passivierungsschicht 14 von dem Halbleitermaterial der obersten Wellenleiterschicht (10.2) getrennt ist, und die zweite Metallisierung 13, die ganzflächig auf der Unterseite des Substrats 1 aufgebracht ist. Die zweite Mantelschicht 15 ist ausreichend hoch für elektrische Leitungen des zweiten Leitfähigkeitstyps dotiert und verjüngt sich gegebenenfalls auf die Breite der Oberfläche der Anti-melt-bach-Schicht 7. Die Begrenzung der zweiten Mantelschicht 15 zu den Wellenleiterschichten 10.1, 10.2 hin kann dann z. B. entsprechend den in Fig. 3 gestrichelt eingezeichneten Linien verlaufen.

Die seitliche Begrenzung des unteren Bereiches dieser zweiten Mantelschicht 15 bzw. die seitliche Begrenzung der darunterliegenden weiteren Anti-melt-back-Schicht 8 begrenzt den Stromfluß des Betriebsstromes auf den unmittelbaren Bereich des Laserstreifens. Der Betriebsstrom fließt vorwiegend durch die Zone der aktiven Schicht 6, da deren Material die geringste Bandlückenenergie besitzt. Ein Stromfluß über die seitlich der aktiven Schicht 6 liegenden Wellenleiterschichten setzt erst dann ein, wenn der Spannungsabfall über den Serienwiderstand der Laserdiode zu groß wird. Durch einen geringen Kontaktwiderstand und eine hohe Dotierung der Kontaktschicht 9, der zweiten Mantelschicht 15 und gegebenenfalls der weiteren Anti-melt-back-Schicht 8 kann dieser Serienwiderstand ausreichend klein gemacht werden. Die Justierung des Steges auf den darunterliegenden Laserstreifen setzt geeignete Apparaturen und Techniken bei der Photolithographie voraus. Mit einer Projektionsbelichtungsmaschine, die gesetzte Marken erkennen kann, ist dies mit ausreichender Genauigkeit möglich. Solche Maschinen entsprechen dem Stand der Technik.

Fig. 4 zeigt den in Fig. 1 bezeichneten Querschnitt durch den mit dem Schalterstrom $I_S$ ansteuerbaren Wellenleiter W im Bereich des Schalters S. Die Stegstruktur des Wellenleiters W dient hier nicht nur der elektrischen Stromführung, sondern auch der optischen Wellenführung. In diesem Bereich umfaßt die auf das Substrat 1 aufgewachsene Schichtfolge die Pufferschicht 2, die Ätzstoppschicht 3, die erste Wellenleiterschicht 10.1, die zweite Wellenleiterschicht 10.2 (und gegebenenfalls weitere Wellenleiterschichten), die erste Mantelschicht 11, die zweite Mantelschicht 15 und die Kontaktschicht 9. Die erste Mantelschicht 11, die zweite Mantelschicht 15 und die Kontaktschicht 9 sind als Steg ausgebildet. Dieser Steg und die Oberfläche der obersten Wellenleiterschicht sind von der Passivierungsschicht 14 bedeckt. Dabei ist von dieser Passivierungsschicht 14 ein für die Kontaktierung vorgesehener Bereich der Oberfläche der Kontaktschicht 9 frei gelassen. Auf diesem Bereich der Kontaktschicht 9 ist eine erste Metallisierung 12 aufgebracht, die außerhalb dieses Kontaktbereiches durch die Passivierungsschicht 14 von dem Halbleitermaterial des Steges bzw. der obersten Wellenleiterschicht isoliert ist. Die erste Metallisierung 12 für den elektrischen Anschluß des Schalters ist für eine getrennte Ansteuerung von der ersten Metallisierung der Laserdiode elektrisch getrennt. In den passiven Bereichen der Oberfläche des Bauelementes, insbesondere dort, wo der Wellenleiter passiv ausgebildet ist, kann die Kontaktschicht 9 entfallen. Die Passivierungsschicht 14 ist in diesen Bereichen ohne Unterbrechung über die ganze Breite des Steges ausgebildet. Die erste Metallisierung 12 des Schalters S bzw. die erste Metallisierung 12 der Laserdiode L kann jeweils auf die kontaktierten Bereiche einschließende eng begrenzte Bereiche, auf Anschlußfelder (Bondpads) und auf leitende Verbindungen zwischen den Kontaktbereichen und diesen Anschlußfeldern begrenzt sein.

Die nachstehende Tabelle enthält für die verschiedenen Schichten des beschriebenen Ausführungsbeispieles Angaben zum Vorzeichen der Dotierung (d), der chemischen Zusammensetzung (ch) und der Grenzwellenlänge Lambda$_g$ in $\mu$m für die jeweilige Materialzusammensetzung.

| | d | ch | $\lambda_g/\mu m$ |
|---|---|---|---|
| Substrat | n | InP | 0,92 |
| Pufferschicht | n | InP | 0,92 |
| Ätzstoppschicht | n | InGaAsP | 1,05 |
| erste Gitterschicht | n | InP | 0,92 |
| zweite Gitterschicht | n | InGaAsP | 1,3 |
| aktive Schicht | | InGaAsP | 1,52 |
| | | | |
| Anti-melt-back-Schicht 7 | p | InGaAsP | 1,3 |
| Anti-melt-back-Schicht 8 | p | InP | 0,92 |
| Kontaktschicht | $p^+$ | InGaAsP | 1,3 |
| erste Wellenleiterschicht | | InGaAsP | 1,3 |
| zweite Wellenleiterschicht | | InGaAsP | 1,05 |
| erste Mantelschicht | p | InP | 0,92 |
| zweite Mantelschicht | p | InP | 0,92 |

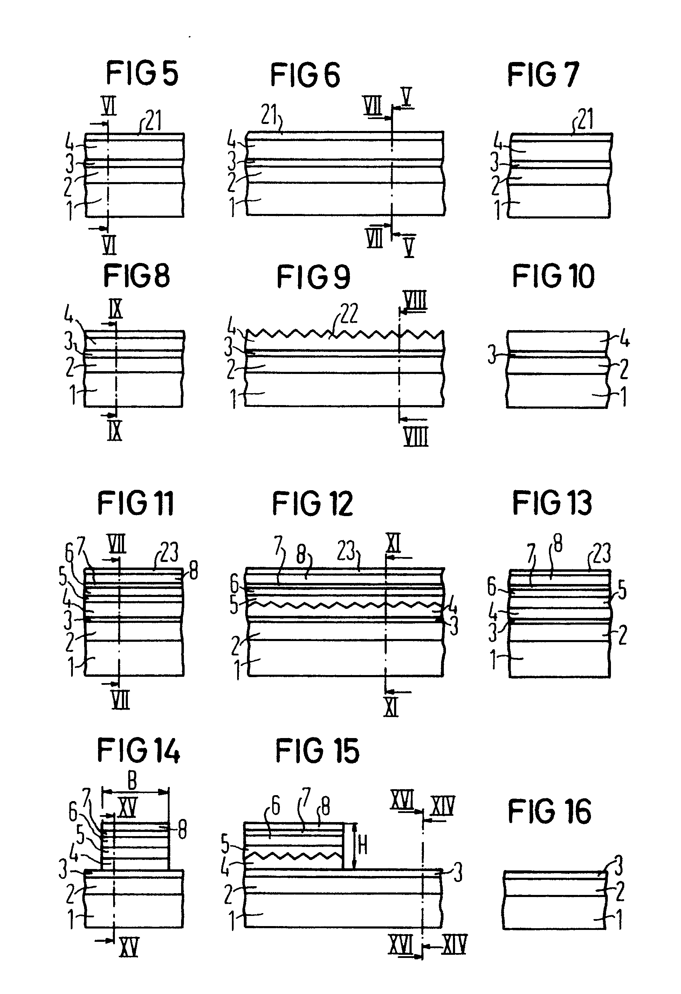

Es folgt eine Beschreibung eines Herstellungsverfahrens für eine erfindungsgemäße Laserdiode-Schalter-Wellenleiter-Struktur anhand der Figuren 5 bis 34. Jeweils drei aufeinanderfolgende, nebeneinander angeordnete Figuren zeigen Quer- bzw. Längsschnitte in jeweils einem Schritt des Herstellungsverfahrens. Die erste Figur auf der linken Seite zeigt den der Fig. 3 entsprechenden Querschnitt durch die Laserdiode L. Die mittlere Figur zeigt jeweils den der Fig. 2 entsprechenden Längsschnitt durch den Übergang von der Laserdiode zum passiven Wellenleiter. Die jeweils dritte, rechts angeordnete Figur zeigt einen Querschnitt durch den geschalteten (entsprechend Fig.4) oder einen ungeschalteten Bereich des Wellenleiters W (jeweils ein Steg).

Auf das Substrat 1 werden nacheinander die Pufferschicht 2, die Ätzstoppschicht 3, die erste Gitterschicht 4 und eine erste Schutzschicht 21 (z. B. InGaAsP der Grenzwellenlänge 1,3 µm) aufgewachsen (Fig. 5 bis 7). Im Anschluß an diesen Epitaxieschritt wird die erste Schutzschicht 21 entfernt und im Bereich der herzustellenden Laserdiode L die Oberfläche der ersten Gitterschicht 4 mit einem Gitter 22 strukturiert (Fig. 8 bis 10). In einem nachfolgenden zweiten Epitaxieschritt werden auf diese erste Gitterschicht 4 nacheinander eine das Gitter 22 einebnende zweite Gitterschicht 5, die aktive Schicht 6, mindestens eine Anti-melt-back-Schicht 7, gegebenenfalls die weitere Anti-melt-back-Schicht 8 und eine zweite Schutzschicht 23, die z. B. dieselbe Materialzusammensetzung wie die erste Schutzschicht 21 haben kann, aufgewachsen (s. Fig. 11 bis 13).

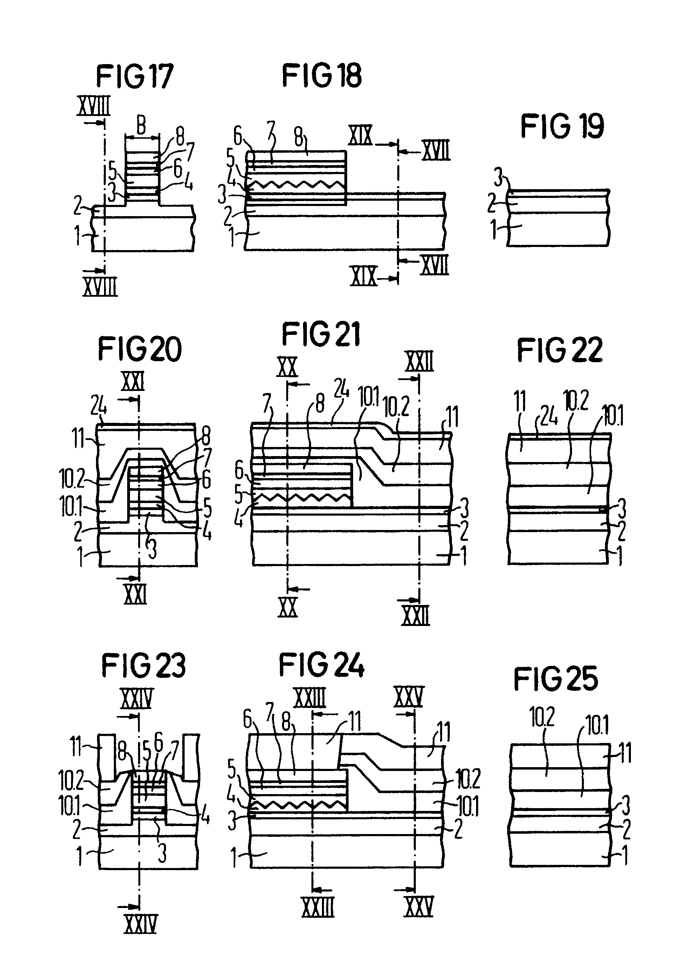

Nach dem Entfernen dieser zweiten Schutzschicht 23 werden die erste Gitterschicht 4, die zweite Gitterschicht 5, die aktive Schicht 6, die Anti-melt-back-Schicht 7 und gegebenenfalls die weitere Anti-melt-back-Schicht 8 außerhalb der für die Herstellung von Laserdioden L vorgesehenen Bereiche weggeätzt. Gegebenenfalls werden Marken für das Arbeiten mit einer oben erwähnten Projektionsbelichtungsmaschine gesetzt. Das in Fig. 14 dargestellte Querschnittprofil dieser für die Laserdiode 11 vorgesehenen Schichtfolge wird in einem nachfolgenden Schritt durch reaktives Ionenstrahlätzen (RIBE) auf die genaue Breite des herzustellenden Laserstreifens geätzt. Dieses Ätzen erfolgt mindestens bis an die Oberfläche der Pufferschicht 2, wobei in den seitlich unmittelbar an den Laserstreifen angrenzenden Bereichen die Ätzstoppschicht 3 vollständig abgetragen wird. Zusätzlich können auch obere Schichtanteile der Pufferschicht 2 in den Bereichen seitlich des Laserstreifens abgeätzt werden. Bei diesem Ätzschritt werden zumindest die für den passiven Wellenleiter W vorgesehenen Bereiche mit einer Maske abgedeckt. Die Schichtfolge im Bereich der Laserdiode erhält danach das Querschnittprofil, wie es in Fig. 17 dargestellt ist. In dem Längsschnitt entsprechend Fig. 15 bzw. Fig. 18, in dem der aus der Pufferschicht 2 herausgeätzte Anteil an einer zusätzlichen Begrenzungslinie erkennbar ist, ist der Übergang von der Laserdiode in den Bereich des passiven Wellenleiters an der seitlichen Begrenzung der für die Laserdiode vorgesehenen Schichtenfolge erkennbar. Die Höhe H dieser Schichtenfolge oberhalb der Ätzstoppschicht 3 im Bereich der Laserdiode beträgt ca. 0,6 $\mu$m. Die Breite B des Laserstreifens wird in dem RIBE-Prozeßschritt von ca. 50 $\mu$m auf ca. 1,5 $\mu$m reduziert.

In einer nachfolgenden Epitaxie werden die erste Wellenleiterschicht 10.1, die zweite Wellenleiterschicht 10.2, die erste Mantelschicht 11 und eine dritte Schutzschicht 24 aufgewachsen (s. Fig. 20 bis 22). Nach dem Entfernen der dritten Schutzschicht 24 wird im Bereich des Lastersteges die erste Mantelschicht 11 entfernt (s. Fig. 23). Dabei wird die Oberfläche der obersten für die Laserdiode vorgesehenen Schicht (Anti-melt-back-Schicht 7 bzw., falls vorhanden, weitere Anti-melt-back-Schicht 8) freigelegt. Von den Wellenleiterschichten 10.1, 10.2 bleibt jeweils ein lateraler Anteil stehen. In Fig. 23 ist der Querschnitt nach dem Entfernen der ersten Mantelschicht 11 auf dem Laserstreifen dargestellt. Der Längsschnitt entsprechend Fig. 24 zeigt den Übergang von der Laserdiode in die Wellenleiterschichten 10.1, 10.2.

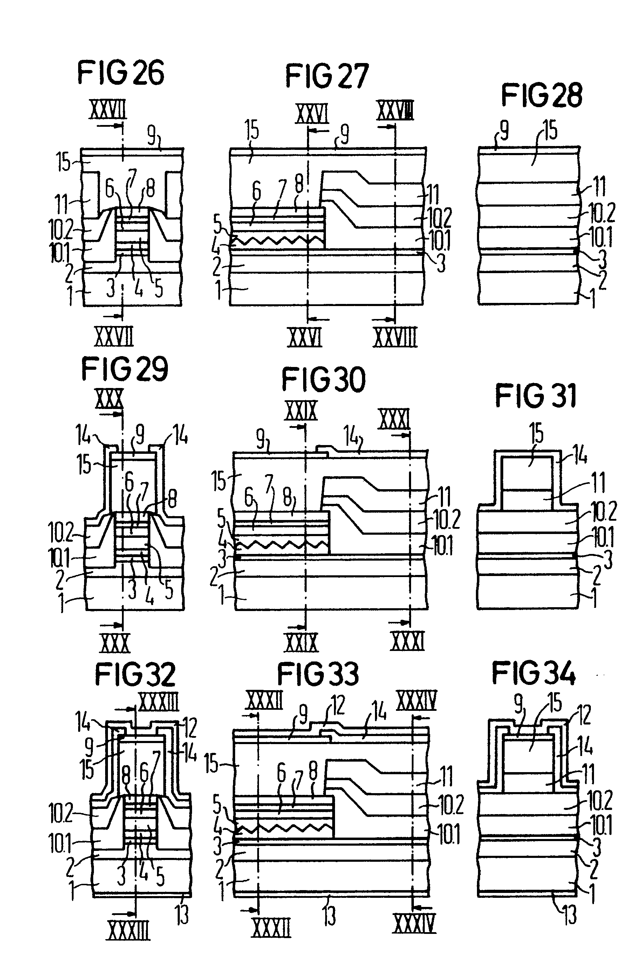

In einer nachfolgenden Epitaxie werden ganzflächig die einebnende zweite Mantelschicht 15 und die Kontaktschicht 9 aufgewachsen. Der Schichtaufbau nach diesem Herstellungsschritt ist in den Fig. 26 bis 28 dargestellt.

Es wird eine flache Zinkdiffusion vorgenommen und die Kontaktschicht 9 in dem als passiv vorgesehenen Bereich entfernt. Die Zinkdiffusion dient dazu, das Halbleitermaterial im Bereich der Oberfläche so hoch zu dotieren, daß ein darauf aufgebrachter Metallkontakt einen ohmschen Kontakt (im Gegensatz zu einem Schottky-Kontakt) bildet. Die Höhe der Dotierung beträgt einige $10^{19}$ cm$^{-3}$. Diese Zinkdiffusion kann in der Weise vorgenommen werden, daß ein zinkhaltiger Film (z. B. Zinkoxid) aufgebracht wird und durch kurzes Erhitzen eine Eindiffusion von Zn in das Halbleitermaterial bewirkt wird. Anschließend wird der Film entfernt. Die Wellenleiterstege werden ausgebildet und im Bereich der Laserdiode auf dem Laserstreifen justiert. Die Passivierungsschicht 14 wird anschließend aufgebracht, was z.B. durch Aufsputtern geschehen kann. Dieser Passivierungsschicht 14 wird in den für die Kontaktierung vorgesehenen Bereichen geöffnet. Es wird die erste Metallisierung 12 aufgebracht und strukturiert. Die zweite Metallisierung 13 wird auf die Unterseite des Substrates ganzflächig aufgedampft.

Der Aufbau vor dem Aufdampfen der ersten und zweiten Metallisierung 12, 13 und nach dem Aufbringen der Passivierungsschicht 14 ist in den Fig. 29 bis 31 dargestellt. Fig. 31 zeigt einen Querschnitt durch den Wellenleiter an einer Stelle des passiven Bereiches. Die Kontaktschicht 9 ist in diesem passiven Bereich entfernt worden und die Passivierungsschicht 14 auf der Oberfläche des Wellenleitersteges durchgehend aufgebracht. Die Figuren 32 und 33 zeigen die erste Metallisierung 12 und die zweite Metallisierung 13 zusätzlich zu dem im übrigen den Figuren 29 und 30 entsprechenden Aufbau. Während Fig. 31 ein Querschnitt durch den Wellenleiter in dessen passivem Bereich zeigt, ist in Fig. 34 der Querschnitt entsprechend Fig. 4 durch einen aktiven Teil des Schalters S dargestellt. Hier ist die Passivierungsschicht 14 auf der Oberseite des Steges unterbrochen und die darauf aufgebrachte erste Metallisierung 12 mit der Oberfläche der Kontaktschicht 9 in Kontakt. Die erste Metallisierung 12 besteht aus mindestens zwei elektrisch voneinander isolierten Anteilen, von denen der eine dem elektrischen Anschluß der Laserdiode L und der andere dem elektrischen Anschluß des aktiven Teils des Schalters S dient. Diese Anteile können jeweils auf den kontaktierten Bereich der Kontaktschicht 9, die zugehörige Anschlußfläche und leitende Verbindungen (Leiterbahnen) jeweils zwischen dem kontaktierten Bereich der Kontaktschicht 9 und der zugehörigen Anschlußfläche strukturiert sein.

Eine Alternative dieses Herstellungsverfahrens sieht vor, in dem Prozeßschritt des reaktiven Ionenstrahlätzens des Laserstreifens als Ätzmaske SiO$_2$ zu verwenden und anschließend auf dem Lasersteg zu lassen. Die Wellenleiterschichten, die in dem anschließenden Prozeßschritt aufgewachsen werden und die erste Mantelschicht 11 wachsen in dem Fall nicht über der SiO$_2$-Ätzmaske auf dem Steg auf. Es ist daher nicht erforderlich, nachfolgend die erste Mantelschicht 11 und die Wellenleiterschichten 10.1, 10.2 oberhalb des Laserstreifens zu entfernen. Nachdem die Ätzmaske von dem Laserstreifen entfernt worden ist, kann dann unmittelbar die zweite Mantelschicht 15 aufgewachsen werden.

Zusätzlich zu dem Vorteil der monolithischen Integration einer DFB-Laserdiode, eines optischen Schalters und Wellenleiterverbindungen hat die vorliegende Erfindung die Vorteile eines einfach herzustellenden Aufbaues und einer direkten Einkopplung (Stoßkopplung) des in der Laserdiode erzeugten Lichtes in den Wellenleiter. Die Eigenschaften und Funktionsweise eines derartigen Schaltkreises sind damit gegenüber dem Stand der Technik wesentlich verbessert worden.

**Patentansprüche**

1.  Monolithisch integrierter Schaltkreis mit mindestens einer Laserdiode (L), mindestens einem optischen Schalter (S) und Wellenleitern (W),
    **dadurch gekennzeichnet,**

- daß die Wellenleiter (W) als Stegwellenleiter ausgebildet sind,
- daß die Laserdiode (L) als DFB-Laserdiode mit einer aktiven Schicht (6) und einem DFB-Gitter in einer ersten Gitterschicht (4), die transversal zu der aktiven Schicht (6) angeordnet ist, ausgebildet ist,
- daß die Laserdiode (L) in bezug auf einen Wellenleiter (W) derart angeordnet ist, daß die in der Laserdiode (L) im Betrieb des Schaltkreises erzeugte Strahlung durch Stoßkopplung in den Wellenleiter (W) eingekoppelt wird und
- daß der optische Schalter in den Steg eines Wellenleiters (W) integriert ist.

2. Schaltkreis nach Anspruch 1,
   **dadurch gekennzeichnet,**
   - daß die Laserdiode (L) streifenförmig übereinander angeordnet eine erste Gitterschicht (4), eine zweite Gitterschicht (5) und eine aktive Schicht (6) hat,
   - daß die erste Gitterschicht (4) und die zweite Gitterschicht (5) voneinander verschiedene Brechzahlen haben,
   - daß die Grenzfläche zwischen der ersten Gitterschicht (4) und der zweiten Gitterschicht (5) eine das DFB-Gitter bildende Gitterstruktur aufweist,
   - daß mindestens eine Wellenleiterschicht (10.1,10.2) in der Ebene der aktiven Schicht (6) vorhanden ist,
   - daß diese Wellenleiterschicht (10.1,10.2) die Laserdiode (L) longitudinal und lateral begrenzt,
   - daß mindestens eine Mantelschicht (11,15), die die Wellenleiterschicht (10.1,10.2) transversal begrenzt und über die die Stromzufuhr in die Laserdiode (L) und in den Schalter (S) erfolgt, vorhanden ist und
   - daß diese Mantelschicht (11,15) streifenförmig ausgebildet ist und die Stege der Wellenleiter (W) bildet.

3. Schaltkreis nach Anspruch 2,
   **dadurch gekennzeichnet,**
   daß auf ein Substrat (1) aus einem Halbleitermaterial, das für elektrische Leitung eines ersten Leitfähigkeitstyps dotiert ist, eine für den ersten Leitfähigkeitstyp dotierte Pufferschicht (2), eine für den ersten Leitfähigkeitstyp dotierte Ätzstoppschicht (3), die für den ersten Leitfähigkeitstyp dotierte erste Gitterschicht (4), die für den ersten Leitfähigkeitstyp dotierte zweite Gitterschicht (5), die aktive Schicht (6) und mindestens eine für den entgegengesetzten zweiten Leitfähigkeitstyp dotierte Anti-melt-back-Schicht (7) übereinander aufgewachsen sind,
   - daß die Pufferschicht (2) und die Ätzstoppschicht (3) ganzflächig aufgewachsen sind,
   - daß die erste Gitterschicht (4), die zweite Gitterschicht (5), die aktive Schicht (6) und die Anti-melt-back-Schicht (7) die für die Laserdiode (L) vorgesehenen lateralen und longitudinalen Abmessungen haben,
   - daß auf die Wellenleiterschicht (10.1,10.2) eine erste Mantelschicht (11) mit der lateralen Abmessung der Stege der Wellenleiter (W) aufgewachsen ist,
   - daß zur Ausbildung der Stege der Wellenleiter (W) eine zweite Mantelschicht (15) über der Laserdiode (L) und über der ersten Mantelschicht (11) aufgewachsen ist,
   - daß ganzflächig eine Passivierungsschicht (14) mit Öffnungen zur Kontaktierung der Laserdiode (L) und des Schalters (S) aufgebracht ist,
   - daß eine erste Metallisierung (12) mit getrennten Anteilen für die Laserdiode (L) und den Schalter (S) aufgebracht ist und
   - daß eine zweite Metallisierung (13) ganzflächig auf der der überwachsenen Seite gegenüberliegenden Seite des Substrates (1) aufgebracht ist.

4. Schaltkreis nach Anspruch 2 oder 3,
   **dadurch gekennzeichnet,**
   daß die erste Gitterschicht (4) InP ist,
   daß die zweite Gitterschicht (5) InGaAsP ist,
   daß die aktive Schicht (6) InGaAsP ist,
   daß jede Wellenleiterschicht (10.1,10.2) InGaAsP ist und
   daß jede Mantelschicht InP ist.

5. Schaltkreis nach einem der Ansprüche 2 bis 4,

**dadurch gekennzeichnet,**
daß der erste Leitfähigkeitstyp n-Leitung und der zweite Leitfähigkeitstyp p-Leitung ist.

6. Schaltkreis nach einem der Ansprüche 2 bis 4,
   **dadurch gekennzeichnet,**
   daß der erste Leitfähigkeitstyp p-Leitung und der zweite Leitfähigkeitstyp n-Leitung ist.

7. Schaltkreis nach einem der Ansprüche 1 bis 6,
   **dadurch gekennzeichnet,**
   daß mindestens ein Schalter (S) und zwei Laserdioden (L) monolithisch integriert sind.

8. Schaltkreis nach einem der Ansprüche 2 bis 6,
   **dadurch gekennzeichnet,**
   daß mindestens zwei übereinander aufgewachsene Wellenleiterschichten (10.1,10.2) unterschiedlicher Zusammensetzungen vorhanden sind.

# FIG 1

# FIG 2

EP 0 454 902 A2

## FIG 3

## FIG 4

10

FIG 5

FIG 6

FIG 7

FIG 8

FIG 9

FIG 10

FIG 11

FIG 12

FIG 13

FIG 14

FIG 15

FIG 16

FIG 17

FIG 18

FIG 19

FIG 20

FIG 21

FIG 22

FIG 23

FIG 24

FIG 25

FIG 26 · FIG 27 · FIG 28 · FIG 29 · FIG 30 · FIG 31 · FIG 32 · FIG 33 · FIG 34